Europäisches Patentamt

European Patent Office

Office européen des brevets

(11) Publication number: **0 269 208**
**A1**

## EUROPEAN PATENT APPLICATION

(21) Application number: 87307748.1

(22) Date of filing: 02.09.87

(51) Int. Cl.4: **C25D 5/16** , C25D 5/10 ,
H05K 3/38

(30) Priority: 26.09.86 GB 8623252

(43) Date of publication of application:
01.06.88 Bulletin 88/22

(84) Designated Contracting States:
DE FR GB

(71) Applicant: ELECTROFOILS TECHNOLOGY
LIMITED
Crescent House
Newcastle-Upon-Tyne NE99 1GE(GB)

(72) Inventor: Torday, John
23 North Avenue
Gosforth Newcastle-Upon-Tyne NE3 4DS(GB)
Inventor: Leetham, Patrick Robert
7 Lesley Avenue
Broadway York, Y01 4JR(GB)

(74) Representative: Allard, Susan Joyce et al
BOULT, WADE & TENNANT 27 Furnival Street
London EC4A 1PQ(GB)

(54) A process for the treatment of copper foil.

(57) A method for the treatment of copper foil comprises depositing onto the copper foil a nodular or dendritic layer of an alloy comprising zinc as the major constitutent thereof. The nodular or dendritic layer may comprise zinc alloyed with at least one of copper, nickel, cobalt or iron.

The foils of the present invention may be bonded to a dielectric substrate, such as an epoxy resin impregnated glass cloth, to form a laminate which may be used in the manufacture of printed circuit boards.

## A PROCESS FOR THE TREATMENT OF COPPER FOIL

The present invention relates to a process for the treatment of copper foil for use in the production of circuit boards in order to improve the adhesion of the foil to a base material, and also to a copper foil prepared by this process and to the laminates prepared therefrom.

Copper foil used in the manufacture of printed circuit boards is usually bonded to a dielectric base material and many proposals have previously been made for improving the strength of the bond between the copper foil and the base material, whilst at the same time attempting to reduce or eliminate the undesirable characteristics of "brown staining" and "undercutting" which are prone to occur on etching.

It is well known in the art to provide a nodular or dendritic layer of copper on the matt side of the copper foil, the dendritic copper layer then being encapsulated by a smooth layer of copper. Prior to lamination the laminate is passivated by, for example, chromate dipping or the cathodic electrolysis of a chromate solution. It is a disadvantage of these laminates that they can suffer from "brown staining" and this defect can result in a lowering of the insulating properties of the base material, as well as a lowering of the peel strength of the copper foil to the base material. In order to overcome these problems it has been proposed to apply to the encapsulating copper layer one or more barrier layers containing zinc, typically of zinc or brass, or one or more barriers layers comprising an alloy of zinc, nickel and at least one other metal.

It has also been proposed to provide a nodular or dendritic layer of zinc or brass on the matt side of the copper foil and then to encapsulate this layer with a layer of copper. A barrier layer of zinc or an alloy of zinc and nickel may be applied thereto.

Whilst the provision of the nodular or dendritic layer of zinc overcomes some of the problems encountered with the dendritic layer of copper proposed hitherto, one disadvantage of the use of such a layer is that it is difficult to encapsulate this layer with a layer of copper because many of the copper plating solutions such as copper sulphate and copper pyrophosphate produce copper deposits which adhere only poorly to the dendritic zinc substrate. The reason for this is the initial deposition of copper by a chemical replacement (cementation) reaction between the copper ion which is deposited and the zinc ion which goes into solution. It has beeen found possible to encapsulate the dentritic zinc layer with a layer of copper by deposition of the copper from a cyanide based copper solution. However, whilst the cyanide based copper plating solution gives an excellent bond between the electrodeposited coopper and the dendritic zinc, there are a number of problems associated with the use of cyanide solutions, such as cost, environmental control and efficient washing.

We have now found that it is possible to co-deposit another metal with the zinc to form a dendritic layer which can then be encapsulated with a copper layer using, for example, a pyrophosphate based copper plating solution.

Accordingly, the present invention provides a method of treating copper foil which comprises depositing onto the copper foil a nodular or dendritic layer of an alloy comprising zinc as the major constituent thereof.

In a preferred aspect of the present invention the nodular or dendritic layer comprises zinc alloyed with copper, the alloy preferably having a content of from 0.3 to 10% by weight of copper. In alternative embodiments of the invention the nodular or dendritic layer may comprise zinc alloyed with a metal other than copper, for example the zinc may be alloyed with at least one of nickel, cobalt or iron.

In carrying out the method of the present invention the zinc alloy is preferably deposited electrochemically onto the copper foil from a suitable electroplating bath. Preferably the electroplating bath will contain zinc ions and ions of the metal to be co-deposited therewith and a complexant, such as sodium gluconate or Rochelle salts. The dendritic zinc layer is generally deposited as a layer of fine crystals with the most prominent crystals growing from the peaks of the matt side of the copper foil.

Whilst not wishing to be bound by any theory, it is believed that the alloying of zinc with another metal alters the solution potential of the zinc dendrites so that the dendritic zinc is not so prone to replacement by copper in a chemical replacement (cementation) reaction. Electrode potential measurements were carried out using a dendrite plated surface in a copper pyrophosphate plating solution against a saturated calomel electrode. The addition of copper increases the corrosion resistance potential of this surface of about 75 millivolts.

The copper foils produced in accordance with the method of the present invention can be readily encapsulated with a layer of copper which may be deposited, for example, from a pyrophosphate based copper plating solution.

The copper foil treated according to the method of the invention with the encapsulating layer of copper may have one or more barrier layers applied thereto. The barrier layer may comprise, for example, an alloy of zinc and nickel, or an alloy of zinc, nickel and at least one other metal.

A preferred barrier layer contains from 0.1 to 4% by weight of lead, from 5% to 25% by weight of nickel, the balance being zinc. The preferred barrier may be deposited by electroplating from a bath containing nickel sulphate, zinc sulphate, ammonia and a citrate using a lead anode, or by electroplating from a bath containing nickel sulphate, zinc sulphate, ammonia, a citrate and lead in solution using, for example, a stainless steel or nickel anode.

The copper foil produced according to the method of the invention having the nodular or dendritic layer of an alloy comprising zinc as the major constituent, the encapsulating copper layer and the barrier layer may then be passivated by means known in the art, such as chromate dipping or by cathodic electroysis of a chromate solution.

The present invention also includes within its scope a laminate which comprises a copper foil produced according to the method of the invention bonded to a dielectric substrate. It will be understood that the choice of dielectric substrate will depend upon the end use for which the laminate is intended. For the manufacture of printed circuit boards a suitable dielectric material is epoxy resin impregnated glass cloth.

Preferably, a laminate according to the invention has a peel strength of greater than 4.5 kp/in, more preferably in the range of from 5.0 to 6.0 kp/in. The preferred laminates of the present invention are particularly suitable for use in the manufacture of printed circuit boards and the present invention includes within its scope printed circuit boards which are produced from these laminates.

EXAMPLE 1

An electrolytic copper foil 35 micrometers thick was treated as follows on the matt side.

1st layer

An electroplating bath was made up to give a composition as follows:-
Zn (as metal)      16 gm/L
NaOH      120 gm/L
Sodium Gluconate      45 gm/L
Cu (as metal)      3 gm/L
The electrolytic copper foil was treated under the following conditions.
Temperature      50°C
Current Density      8 amps/dm²
Time      11 secs
Anode      Stainless steel (Grade 316L)

A fine layer of copper containing zinc dendrites was deposited with the most prominent crystals growing from the peaks of the matt side of the copper foil.

2nd layer

After washing the dendritic first layer was encapsulated with copper from the following electroplating solution under the conditions as detailed below.
Copper pyrophosphate trihydrate      100 gm/L
Potassium pyrophosphate (anhydrous)      350 gm/L
Ammonia      6 ml/L
pH      9
Temperature      55°C
Current density      9 amps/dm²
Time      30 secs
Anode      Copper

3rd layer

The encapsulating copper second layer was washed carefully and then a barrier layer applied from an electroplating solution under the conditions as detailed below.
$ZnSO_4$ $1H_2O$      100 gm/L
$NiSO_4$ $6H_2O$      50 gm/L
Citric Acid      100 gm/L
Pb as acetate      50 ppm
pH (by addition of ammonia)      9.2
Temperature      25°C
Current density      3 amps/dm²
Time      11 secs
Anode      Stainless steel (Grade 316L)

4th layer

After washing the foil was stain proofed either by dipping or by cathodic electrolysis in a dilute chromic acid solution. The foil was then washed again and dried.

On laminating to a standard FR4 grade epoxy resin/glass prepreg a peel strength after solder float of 5.5 kp/in was obtained. The undercut on soaking in dilute hydrochloric acid was negligible. On peeling the treatment layers stayed firm and there was no transfer of any of the treatment layers on to the epoxy resin/glass dilectic base.

## EXAMPLE 2

An electrolytic copper foil 35 micrometers thick were treated as follows on the matt side.

1st layer -as in Example 1.

2nd layer -As in Example 1, but the current density was reduced to 3amps/dm² and the time to 18 seconds.

3rd layer

An electroplating bath was made up to give a composition as follows:-

Copper (ion concentration as sulphate)     65gm/L
Sulphuric Acid     75gm/L

A further encapsulating layer was applied from this solution to the foil under the following conditions.

Temperature     55°C
Current Density     10 amps/dm²
Time 18 Seconds
Anode Lead Alloy

4th layer -As 3rd layer in Example 1.

5th layer -As 4th layer in Example 1.

After washing the foil was stain proofed either by dipping or by cathodic electrolysis in a dilute chromic acid solution. The foil was then washed again and dried.

On laminating to a standard FR4 grade epoxy resin/glass prepreg a peel strength after solder float of 5.5 kp/in was obtained. The undercut on soaking in dilute hydrochloric acid was negligible. On peeling the treatment layers stayed firm and there was no transfer of any of the treatment layers on to the epoxy resin/glass dilectric base.

## Claims

1. A method of treating copper foil which comprises depositing onto the copper foil a nodular or dendritic layer of an alloy comprising zinc as the major constituent thereof.

2. A method as claimed in claim 1 wherein the nodular or dendritic layer comprises zinc alloyed with at least one of copper, nickel, cobalt or iron.

3. A method as claimed in claim 2 wherein the alloy comprises from 0.3 to 10% by weight of copper.

4. A method as claimed in any one of the preceding claims wherein the zinc alloy is deposited electrochemically onto the copper foil.

5. A method as claimed in any one of the preceding claims wherein after the deposition of the nodular or dendritic layer of an alloy comprising zinc as the major constituent, the said nodular or dendritic layer is encapsulated with a layer of copper.

6. A method as claimed in claim 5 wherein the copper layer is deposited electrochemically from a pyrophosphate based electroplating bath.

7. A method as claimed in claim 5 or claim 6 which comprises applying over the encapsulating copper layer one or more barrier layers.

8. A method as claimed in claim 7 wherein the barrier layer comprises an alloy of zinc and nickel, or an alloy of zinc, nickel and at least one other metal.

9. A method as claimed in claim 8 wherein the barrier layer comprises from 0.1 to 4% by weight of lead, from 5 to 25% by weight of nickel, the balance being zinc.

10. A method as claimed in any one of the preceding claims wherein the treated copper foil is passivated, preferably by chromate dipping or by the cathodic electrolysis of a chromate solution.

11. A laminate which comprises a copper foil prepared by a process as claimed in any one of the preceding claims bonded to a dielectric substrate.

12. A laminate as claimed in claim 11 wherein the copper foil is bonded to an epoxy resin impregnated glass cloth.

13. A laminate as claimed in claim 11 or claim 12 for use in the manufacture of printed circuit boards.

European Patent Office

# EUROPEAN SEARCH REPORT

Application Number

EP 87 30 7748

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | US-A-4 456 508 (TORDAY) | | C 25 D 5/16 |
| | --- | | C 25 D 5/10 |
| A | EP-A-0 112 635 (TORDAY) | — | H 05 K 3/38 |
| | ----- | | |

TECHNICAL FIELDS SEARCHED (Int. Cl.4)

C 25 D 5/10
C 25 D 5/16
H 05 K 3/38

The present search report has been drawn up for all claims

| Place of search | Date of completion of the search | Examiner |
|---|---|---|
| THE HAGUE | 02-02-1988 | VAN LEEUWEN R.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................

& : member of the same patent family, corresponding document

EPO FORM 1503 03.82 (P0401)